# EUROPEAN PATENT APPLICATION

(11) **EP 1 482 532 A1**
(43) Date of publication of application: **01.12.2004**
(21) Application number: 03011849.1
(22) Date of filing: 26.05.2003
(51) Int. Cl.: H01J 37/04, H01J 37/30

(54) **GRADIENT FIELD DEFLECTOR**

(71) Applicant: ICT Integrated Circuit Testing Gesellschaft für Halbleiterprüftechnik mbH, 85551 Heimstetten (DE)
(72) Inventor: Rechav, Betsalel Tzvi, Kiryat Tivon (IL); Adamec, Pavel, 85540 Haar (DE); Akerman, Lior, Kohav Yair 44864 (IL)
(74) Representative: Zimmermann, Gerd Heinrich

(57) **Abstract**

A deflector for imposing a deflection force on a beam of charged particles is provided, said deflector comprising a pair of electrodes (1A, 1B) extending along the direction (Z) of the beam and a first direction (X) substantially normal to said direction (Z) of the beam, wherein said pair of electrodes (1A, 1B) is angled with respect to said first direction (X). Preferably, the deflection force varies substantially linearly within said region of interest.

## Description

### FIELD OF THE INVENTION

The present invention relates to a deflector for a charged particle beam exerting a varying deflection force onto said charged particle beam, especially a substantially linear varying deflection force.

### BACKGROUND OF THE INVENTION

A variety of methods have been used to examine microscopic surface structures of semiconductors. These have important applications in the field of semiconductor chip fabrication, where microscopic defects at a surface layer make the difference between a good or bad chip. Holes or vias in an intermediate insulating layer often provide a physical conduit for an electrical connection between two outer conducting layers. If one of these holes or vias becomes clogged, it will be impossible to establish this electrical connection and the whole chip may fail. Examination of microscopic defects on the surface of the semiconductor layers is necessary to ensure quality control of the chips.

Charged particle beams have several advantages over other mechanisms to examine samples. Light beams have an inherent resolution limit of about 100 nm to 200 nm, but charged particle beams can investigate feature sizes as small as a few nanometers. Charged particle beams are manipulated fairly easily with electrostatic and electromagnetic elements, and are easier to produce and manipulate than x-rays.

However, charged particle beams have relatively small diameters and, accordingly, it takes much time to scan a sample completely. This results in low throughput which is disadvantageous in mass production applications. For this reason, it has been proposed to arrange many charged particle sources in an array and to operate them in parallel so that a much larger area can be inspected at the same time. As an example, field emitter cathodes can be manufactured in such an array structure.

As has been mentioned above, charged particle beams are manipulated fairly easily with electrostatic and electromagnetic elements, e.g. electrodes and coils. Existing deflectors for charged particle beams are commonly used for uniform deflection in a pre-defined direction or to correct aberrations of the charged particle beam.

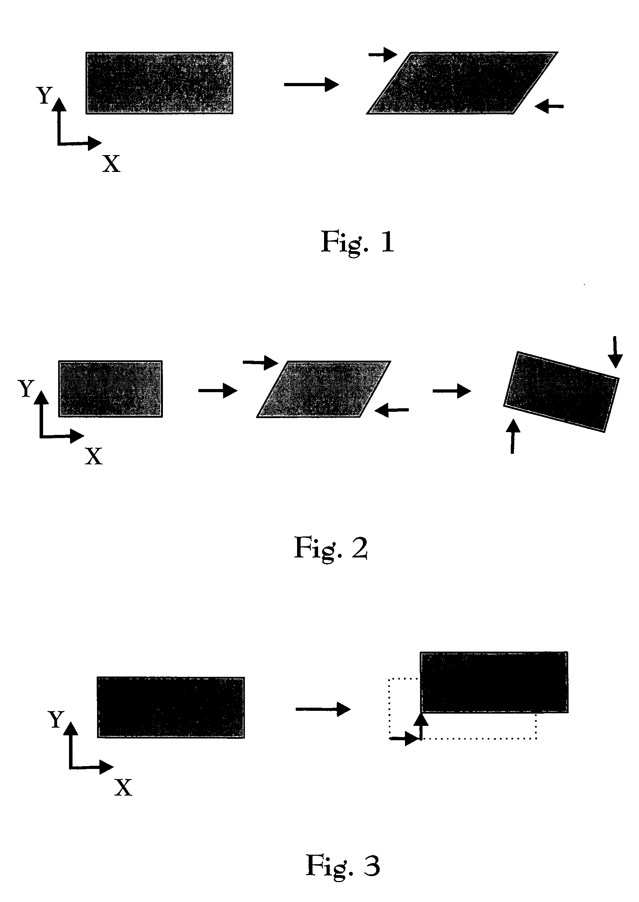

The operation of such a prior art deflector system is now described with respect to Fig. 3. The left hand side of Fig. 3 shows a rectangle which corresponds to the cross-section of a charged particle beam produced by an emitter array. On the right hand side of Fig. 3, the effect of the deflectors is shown in that the rectangle is shifted in x direction as well as in y direction.

However, for some applications it is necessary to skew the cross-section of the charged particle beam. However, the aforementioned prior art deflectors are not capable of skewing since they only shift the beam in a predetermined direction. Furthermore, it is especially desirable to have an electrically controllable skew.

### SUMMARY OF THE INVENTION

It is therefore an object of the present invention to provide an improved deflector, and especially a deflector which is capable to skew a beam of charged particles, preferably a deflector in which the skew can be electrically controlled.

These and other objects are solved by a deflector according to claims 1, 2, 3, 5, 7, 8 and 10, a deflector system according to claim 17 and a charged particle apparatus according to claim 18. Further advantages, features, aspects and details of the invention are evident from the dependent claims, the description and the accompanying drawings. The claims are intended to be understood as a first non-limiting approach of defining the invention in general terms.

According to an embodiment of the present invention, a deflector for imposing a deflection force on a beam of charged particles is provided, wherein said deflection force varies within a region of interest along a first direction substantially normal to the beam and is directed in a second direction substantially normal to the beam.

Since the deflection force is directed in a second direction but varies in a first direction, the strength of the deflection force is non-uniform along the first direction. Accordingly, a stronger deflection force is exerted on some parts of the beam than on other parts of the beam. Thus, a skew of the beam results.

According to another embodiment of the present invention, a deflector for imposing a deflection force on a beam of charged particles is provided, comprising a pair of electrodes extending along the direction of the beam and a first direction substantially normal to said direction of the beam, wherein a first electrode is oriented parallel to said first direction and a second electrode is angled with respect to said first direction.

Since one of the electrodes is angled with respect to the first direction, the distance between the electrodes is not constant but varies along the first direction. Since the strength of the deflection force depends on the distance between the electrodes, the deflection force is stronger at the end where the electrodes are near and weaker at the end where the electrodes are farther from each other. Therefore, the deflector of the above embodiment is capable of skewing a charged particle beam and provides a simple and easy to implement realization.

According to a further embodiment of the present invention, a deflector for imposing a deflection force on a beam of charged particles is provided, comprising a pair of electrodes extending along the direction of the beam and a first direction substantially normal to said direction of the beam, said pair of electrodes being angled with respect to said first direction.

This embodiment is similar to the embodiment described before and is based on the same working principle. However, the variation of the deflection force can be achieved with a smaller inclination of a single electrode since both electrodes are angled with respect to the first direction and their respective inclinations add together.

According to yet another embodiment of the present invention, a deflector for imposing a deflection force on a beam of charged particles, comprising first and second pairs of electrodes extending along the direction of the beam and a first direction substantially normal to said direction of the beam, said first and second pairs of electrodes being angled with respect to said first direction wherein the angle between a first electrode of said first pair and said first direction and the angle between a second electrode of said first pair and said first direction are equal in magnitude but have opposite sign, and wherein the angle between a first electrode of said second pair and said first direction and the angle between a second electrode of said second pair and said first direction are equal in magnitude but have opposite sign, and wherein the angle between said first electrode of said first pair and said first direction and the angle between said second electrode of said second pair and said first direction are equal in magnitude and sign, and wherein the angle between said second electrode of said first pair and said first direction and the angle between said first electrode of said second pair and said first direction are equal in magnitude and sign.

The above arrangement allows for a variation of the deflection force, wherein the deflection force changes its sign within a region of interest. Thus, the end sides of the beam can be pulled in opposite directions. Furthermore, the above embodiment is especially useful when each of the electrodes is equally electrically charged by magnitude, but the first electrode of the first pair and the second electrode of the second pair are charged with electrical charge of the opposite sign of the charge of the second electrode of the first pair and the first electrode of the second pair. This results in a very symmetric geometry for the deflection force.

According to a further embodiment of the present invention, a deflector for imposing a deflection force on a beam of charged particles is provided, which comprises at least four pairs of electrodes extending along the direction of the beam and a first direction substantially normal to said direction of the beam, said four pairs being oriented parallel to a plane spanned by the center of the beam and the first direction and being oriented normal to a plane spanned by the center of the beam and a second direction substantially normal to the beam.

With such an arrangement of the electrodes, it is possible to create an inhomogeneous deflection force without the need of introducing an angle into the system since the electrodes are oriented parallel to given symmetry planes of the system, i.e. of the beam. Preferably, the first pair and second pair of electrodes are oppositely charged to the third and fourth pair of electrodes. Even more preferably, the charge of the first and fourth pair is greater than that of the second and third pair, respectively. Thus, a substantially linearly varying deflection force can be generated within a region of interest.

According to yet a further embodiment of the present invention, a deflector for imposing a deflection force on a beam of charged particles in a direction substantially normal to the beam, comprising at least two coils, wherein said coils are oriented parallel to a plane spanned by said beam and said direction substantially normal to the beam.

When coils are used instead of electrodes, no inclination of the coils is necessary. The variation of the deflection force is controlled by the currents in the coils and can, therefore, be manipulated and controlled easier than in the case of electrodes. To achieve a symmetric geometry, it is especially preferred that a currents in the coils are equal in magnitude but of opposite sign.

According to another embodiment of the present invention, a deflector for imposing a deflection force on a beam of charged particles is provided, said deflector comprising first and second pairs of coils, said first and second pairs of coils being oriented in a plane spanned by first and second directions substantially normal to the beam, wherein upper electrodes of said first and second pairs are disposed above a plane of interest, and wherein lower electrodes of said first and second pairs of electrodes are disposed below said plane of interest.

This embodiment is especially interesting in cases where a lengthy substrate, e.g. a wafer, is disposed in the plane of interest. Then, it may be a problem or even impossible to orient coils perpendicular to the plane of interest since their loops would interfere with the lateral extensions of substrate. However, the above deflector allows to generate a substantially linearly varying deflection force even in this case since the coils generating the magnetic field are disposed above and below said plane of interest so that no interference between the coils and the substrate occurs.

According to an even further embodiment of the present invention, a deflector system comprising at least two deflectors according to any of the preceding claims, wherein first and second deflectors are serially disposed downstream the direction of a beam of electrically charged particles, said second deflector being rotated around said beam about 90° with respect to said first deflector.

The deflector system of the above embodiment allows for a first skew in a first direction and a second skew in a second direction normal to the first direction. If properly applied, these two skews result in a rotation of the cross-section of the beam.

In all of the above described embodiments of the present invention, it is especially preferred that the deflection force varies substantially linearly within a region of interest.

It should also be noted that it is a desired advantage of all the embodiments according to the present invention that the skew of the electron beam is electrically, and thus simply, controlled, e.g. by applying different voltages to electrodes or by applying different currents to coils.

### BRIEF DESCRIPTION OF THE DRAWINGS

Some of the above indicated and other more detailed aspects of the invention will be described in the following description and partially illustrated with reference to the figures. Therein:
Fig. 1 shows the result of a skew of a cross-section of a charged particle beam.
Fig. 2 shows the result of two subsequent skews of a cross-section of a charged particle beam.
Fig. 3 shows the result of the deflection of the beam with a deflector according to the prior art.
Fig. 4a shows a first variation of the field strength within a region of interest.
Fig. 4b shows a first variation of the deflection amplitude within a region of interest.
Fig. 5a shows a second variation of the field strength within a region of interest.
Fig. 5b shows a second variation of the deflection amplitude within a region of interest.
Fig. 6a is a perspective view of a deflector according to an embodiment of the present invention.
Fig. 6b is a sectional view of a deflector according to an embodiment of the present invention.
Fig. 6c is a sectional view of a deflector according to a further embodiment of the present invention.
Fig. 7a shows the relationship between a desired skew operation and a deflection amplitude.
Fig. 7b is a sectional view of a deflector capable of the skew operation described in Fig. 7a.
Fig. 8a is a perspective view of a deflector according to another embodiment of the present invention.
Fig. 8b is a sectional view of the deflector shown in Fig 8a.
Fig. 9 is a sectional view of a deflector according to a further embodiment of the present invention.
Fig. 10a is a perspective view of a deflector according to yet a further embodiment of the present invention.
Fig. 10b is a sectional view of the embodiment shown in Fig. 10a and shows the variation of the field strength in this embodiment.
Fig. 10c shows the variation of the deflection amplitude.
Fig. 11 a shows the relationship between a desired skew operation and a deflection amplitude.
Fig. 11b is a sectional view of a deflector capable of the skew operation described in Fig. 11a.
Fig. 12 a shows a deflector according to another embodiment of the present invention.
Fig. 12b is a plan view of a coil configuration of the embodiment shown in Fig. 12a.
Fig. 13 shows a deflector system according to another embodiment of the present invention.
Fig. 14 shows a deflector system according to a further embodiment of the present invention.

### DESCRIPTION OF THE PREFERRED EMBODIMENTS

Fig. 1 shows the result of a skew of a cross-section of a charged particle beam, hereinafter exemplary referred to as an electron beam, when deflected by a deflector according to an embodiment of the present invention. On the left hand side of Fig 1, the undisturbed cross-section of the beam is shown which is then subjected to a deflection force designated by the little arrows at the upper left and lower right edges of the cross-section. The forces acting on the upper left and lower right edges are different, other than in the deflection known in the art and shown in Fig. 3 where the same deflection force is exerted to every point within the cross-section.

Fig. 2 shows the result of two subsequent skews of a cross-section of a charged particle beam. As a starting point, the undisturbed cross-section is again shown on the left hand side of Fig. 2 and is then subjected to a deflection force as in Fig. 1. The result of this skew is shown in the middle part of Fig. 2. Subsequently, the already skewed cross-section is subjected to a further deflection. However, in this second deflection, the deflection force is oriented normal to the direction of the deflection force in the first deflection. The result of this second deflection is shown on the right hand side of Fig. 2. As a result, the cross-section of the beam has been rotated due to the subsequent skew operations. Although the above description related to a two-dimensional cross-section of the beam, it should be understood that also on-dimensional cross-sections, e.g. generated by a row of emitters, can be also skewed by the embodiments of the present invention.

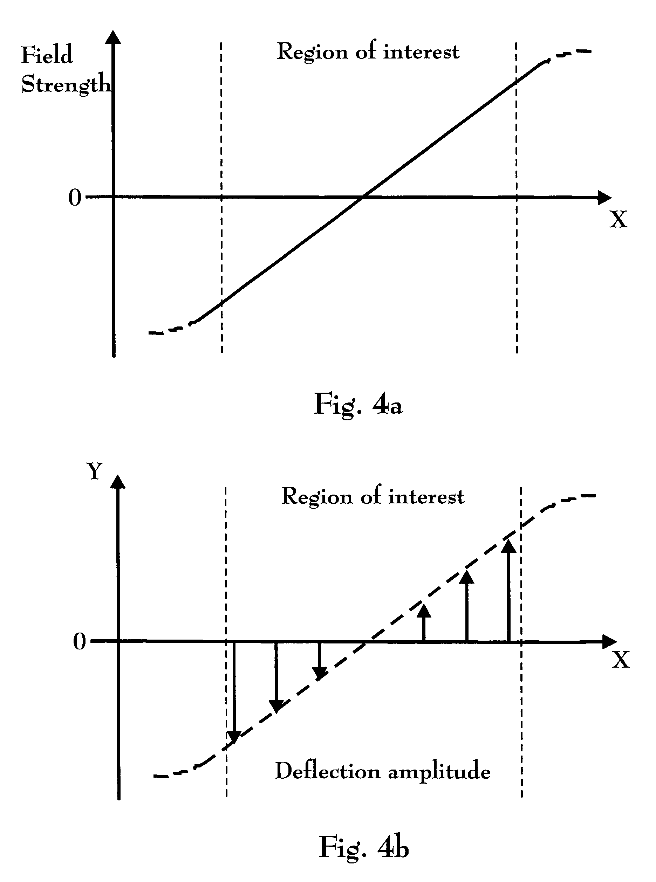

The deflection force for accomplishing the aforementioned skew operations is generated by an electric or magnetic field. A possible variation of the field strength is shown in Fig. 4a. Therein, the field strength varies along the x-direction and continually increases from the left to the right. Furthermore, the field is anti-symmetric with respect to the center of the region of interest. Preferably, the field strength varies substantially linearly within a region of interest. This region of interest is defined by the dimensions of the beam cross-section and the deflector geometry. Particularly, the cross-section of the beam must be fully contained within the region of interest, i.e. the region of interest must have at least the dimension of the beam cross-section in the x-direction. Preferably, the region of interest is considerably larger than the cross-section of the beam. Fig. 4b shows the deflection amplitude, i.e. the deflection force, within the region of interest for the field shown in Fig. 4a. As can be seen, the deflection force is directed in the y-direction but varies in strength along the x-direction, i.e. the direction of the deflection is perpendicular to the direction along which the field varies.

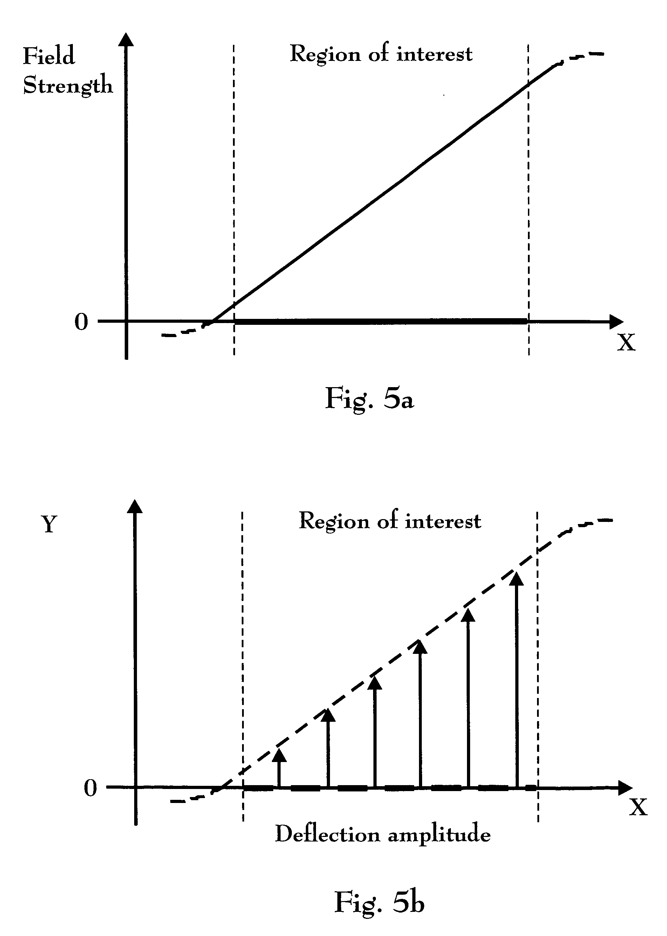

Another possible variation the field strength is shown in Fig. 5a. Therein, the field strength varies along the x-direction and continually increases from the left to the right. However, a constant field component is added to the substantially linearly varying field within a region of interest. Thereby, a field can be created that does not null in the center of the region of interest but in any other point within or outside the region of interest. Moreover, even a field that does not null at all an be created by adding a constant field to the varying component. The corresponding deflection amplitude is shown in Fig. 5b, where it can be seen that in the case when the field does not null within the region of interest, also the direction of the deflection force is constant throughout the region of interest.

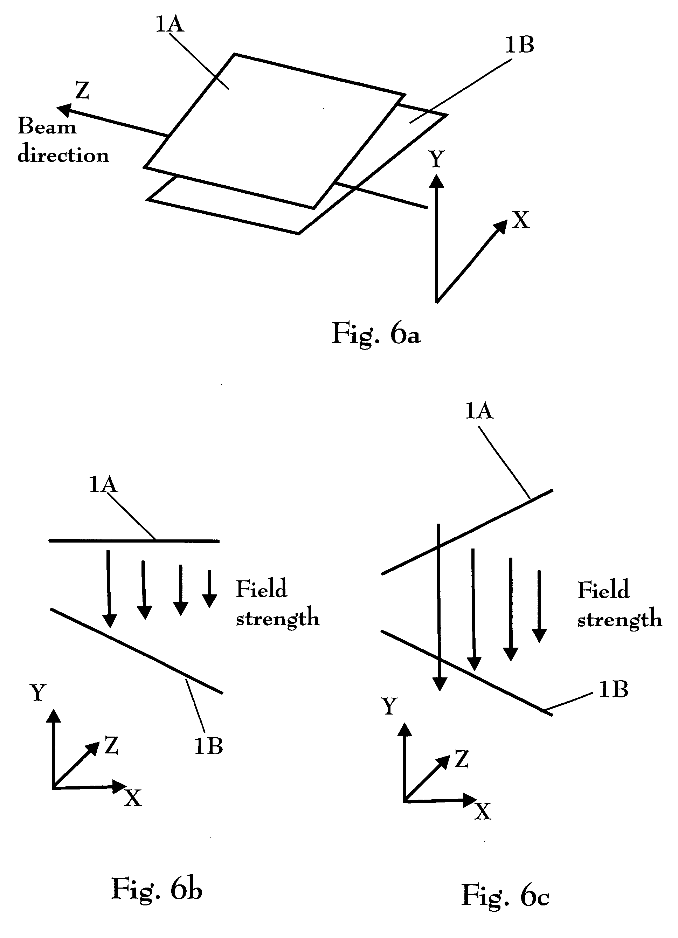

Fig. 6a is a perspective view of a deflector according to an embodiment of the present invention comprising a first electrode 1A and a second electrode 1B. These electrodes are primarily oriented along the x-z-plane, but at least one of these electrodes 1A, 1B is angled with respect to the x-z-plane. In this context, it should be understood that the electron beam extends in the z-direction, i.e. the z-direction is the direction of the speed of the electrons.

Fig. 6b is a sectional view of a deflector according to the aforementioned embodiment of the present invention. In this embodiment, a first electrode 1A is oriented parallel to the x-z-plane and a second electrode 1B is angled with respect to the x-z-plane. The distance between the first and second electrodes 1A, 1B varies along the x-direction due to the inclination of the second electrode 1B. Since the electric field strength depends on the distance between the electrodes, also the electric field strength varies along the x-direction. As is indicated by the different lengths of the arrows, the field strength is greater for smaller distances and smaller for larger distances. Accordingly, the field strength decreases from the left to the right in Fig. 6b.

Fig. 6c is a sectional view of another possibility of forming a deflector according to an embodiment of the present invention. The second electrode 1B is angled with respect to the x-z-plane as in the above described embodiment. However, also the first electrode 1A is angled with respect to the x-z-plane. Preferably, the angle between the x-z-plane and each of the electrodes 1A, 1B, 1C, 1D is between 1° and 10°. It is also preferred that the angle between the x-z-plane and both electrodes 1A, 1B is equal in magnitude but opposite in sign. In other words, the first and second electrodes 1A, 1B have mirror symmetry with respect to the x-z-plane. As in the above described embodiment, the distance between the first and second electrodes 1A, 1B varies along the x-direction due to the inclination of the electrodes. Accordingly, the field strength decreases from the left to the right also in Fig. 6c.

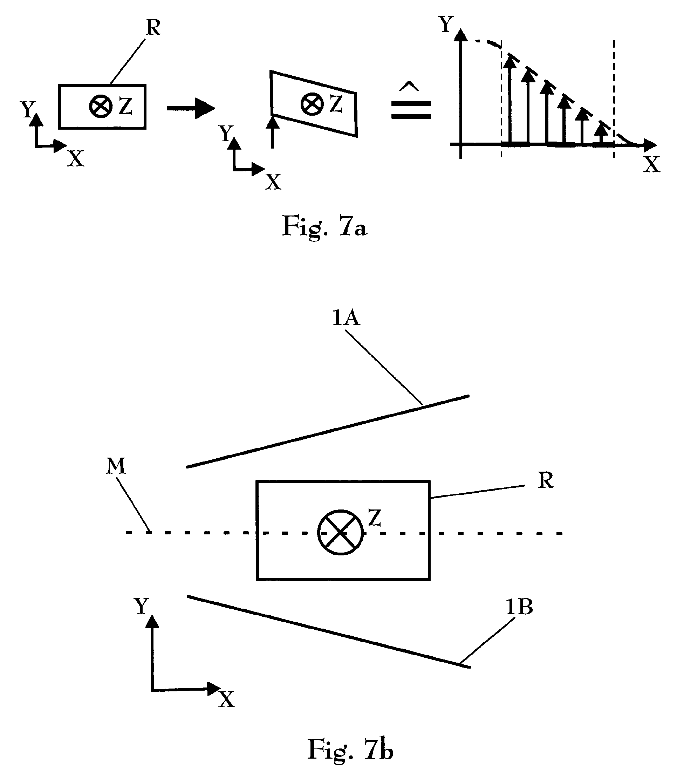

The operation of the above described embodiment is now described with reference to Figs. 7a and 7b. On the left hand side of Fig. 7a, the undeflected cross-section R of the electron beam extending in the z-direction is shown. The middle part of Fig. 7a shows the intended skew of cross-section R by a deflection force. On the right hand side of Fig. 7a, the deflection force causing the skew shown in the middle part is depicted. As can be seen, the deflection force decreases from the left to the right. Fig 7b shows the geometry of the deflector 1A, 1B and the cross-section R. The first and second electrodes 1A, 1B of the deflector are disposed mirror-symmetrical with respect to a mirror plane M parallel to the x-z-plane and extending through the center of the cross-section R. Then, the electrodes are charged and form an electric field as shown on the right hand side of Fig. 7a. Since the deflection force acts strongest at the left of cross-section R, a skew as shown in the middle part of Fig. 7a is accomplished.

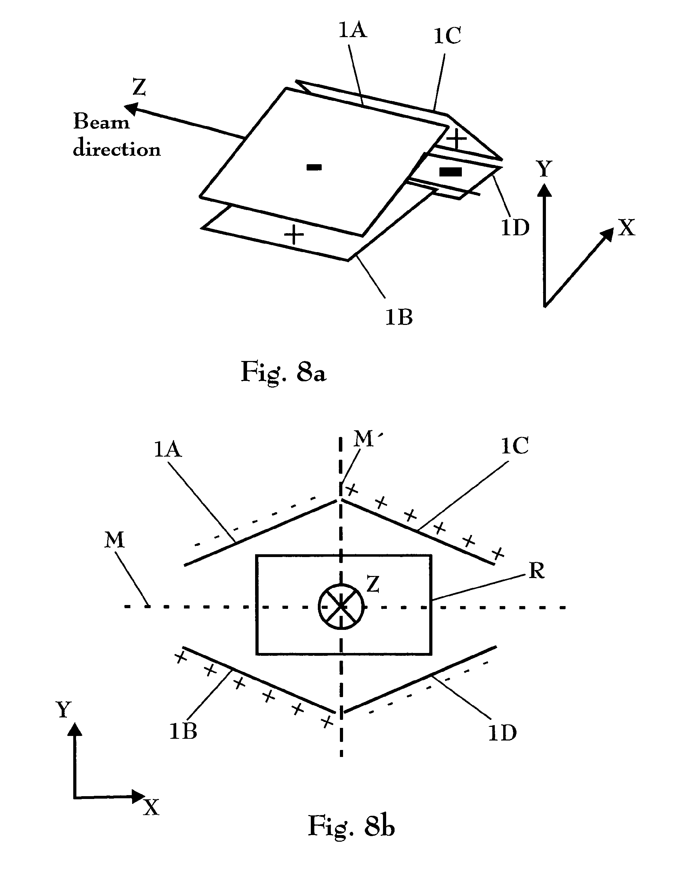

A further embodiment of the present invention is now described with reference to Figs. 8a and 8b. Fig. 8a is a perspective view of a deflector according to this further embodiment of the present invention. The deflector comprises four electrodes 1A, 1B, 1C, 1D which are arranged in a first pair 1A, 1B and a second pair 1C, 1D. Each of the first and second pairs is similar to the deflector shown in Fig. 7b in that the two electrodes constituting the pair are arranged mirror-symmetrically with respect to a mirror plane M parallel to the x-z-plane and extending through the center of the cross-section R of the beam. Furthermore, the electrodes of each pair are angled with respect to the x-z-plane. However, a second mirror plane M' is present in this embodiment. This second mirror plane M' is oriented parallel to the y-z-plane and extends also through the center of the cross-section R of the beam. The first and second pairs of electrodes are also mirror-symmetrically arranged with respect to this second mirror plane M'. Especially, none of the electrodes extends beyond the second mirror plane M'. In other words, each of the electrodes 1A, 1B, 1C, 1D is disposed within a different quadrant of the x-y-plane in a sectional view when the center of the beam cross-section R defines the origin. Accordingly, the present embodiment exhibits a mirror symmetry with respect to the first M and second M' mirror planes.

Next, the operation of the embodiment shown in Figs. 8a and 8b is described. The deflector of the embodiment shown in Figs. 8a and 8b is capable of producing a field as shown in Fig. 4a and, consequently, a deflection force as shown in Fig. 4b. To this end, each of the electrodes is equally charged by magnitude, i.e. the magnitude of the charge of each electrode is equal. However, the signs of the charges are different, namely they are point-symmetric with respect to the center of the cross-section R of the beam. In other words, if the upper electrode 1A of the first pair is negatively charged, the lower electrode 1B of the first pair is positively charged, the upper electrode 1C of the second pair is positively charged and the lower electrode of the second pair is negatively charged. In such an arrangement, the deflection amplitude as depicted in Fig. 4b is realized. However, if a non-symmetric field is required, the charges of the electrodes can be varied accordingly.

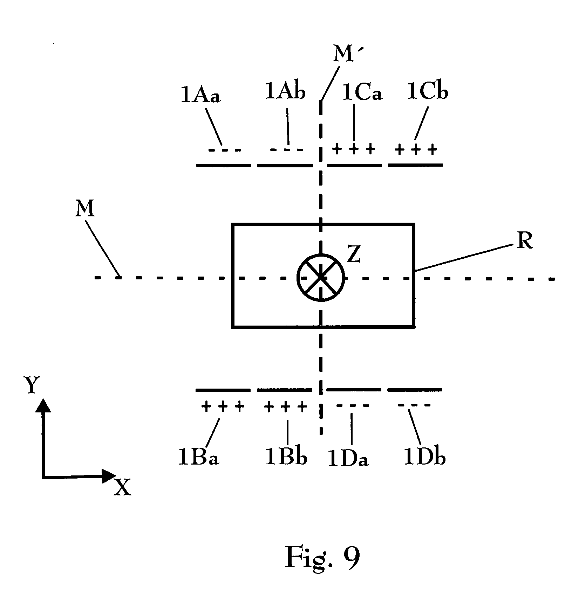

Another embodiment of the present invention is now described with reference to Fig. 9. A first pair of electrodes 1Aa, 1Ba is disposed parallel and mirror-symmetric with respect to a mirror plane M parallel to the x-z-plane and extending through the center of the cross-section R of the beam. Likewise, second 1Ab, 1Bb, third 1Ca, 1Da and fourth 1Cb, 1Db pairs of electrodes are provided parallel and mirror-symmetric to plane M. Furthermore, the pairs are also arranged mirror-symmetric and normal to a second mirror plane M' parallel to the y-z-plane and extending through the center of the beam cross-section R.

In operation, the first and second pairs are oppositely charged with respect to the third and fourth pair. Furthermore, it is preferred that the first pair 1Aa, 1Ba is more charged than the second pair 1Ab, 1Bb, e.g. by applying a higher voltage between the electrodes of the first pair compared to the voltage applied between the second pair. Similarly, the fourth pair 1Cb, 1Db is more charged than the third pair 1Ca, 1Da. Thus, a deflection force can be established which varies substantially linear in the x-direction. The strength of this deflection force can be controlled electrically, e.g., by individually controlling the charging voltages of the electrode pairs. Especially, the above embodiment can be implemented in existing charged particle beam apparatus, e.g., by segmenting built-in deflectors.

With respect to the above described embodiments, it should be understood that, although they are shown as straight lines in the sectional views, they are not necessarily plain. Rather, their shape may be optimized such that a substantially varying field is created in the region of interest.

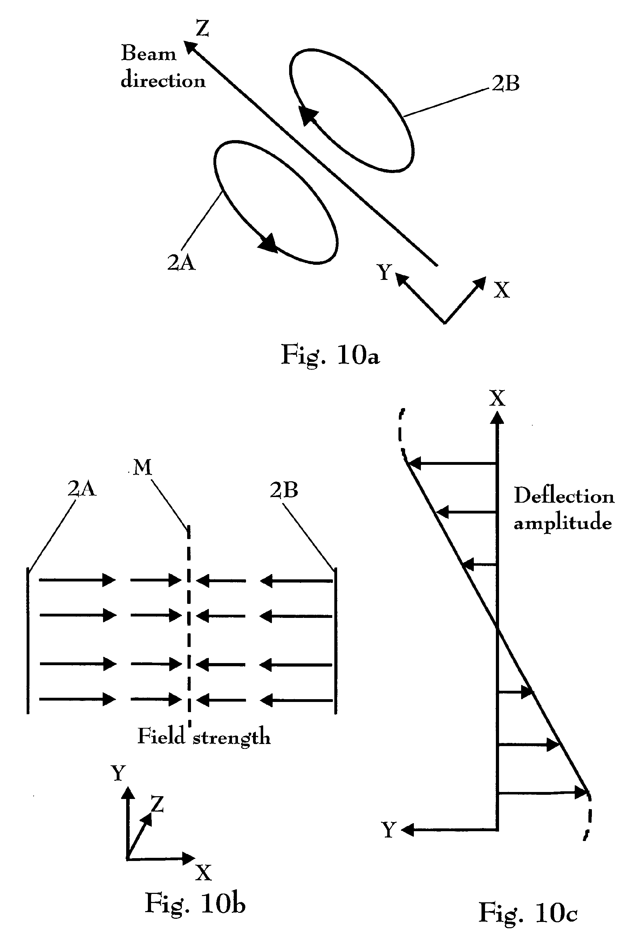

Next, an embodiment of the present invention will be described with reference to Figs. 10a, 10b and 10c. In this embodiment, coils 2A, 2B are used to create a magnetic field that causes the deflection force on the electrons. The coils 2A, 2B are oriented parallel to the y-z-plane, as can be also seen from Fig. 10b. Currents are applied to the coils to form a magnetic field between them. Thereby, the current in a first coil 2A and the current in a second coil 2B have opposite direction. Preferably, the currents of the first and second coil are equal in magnitude.

The resulting magnetic field is depicted by the arrows in Fig. 10b. The field is mirror-symmetric with respect to a mirror plane M extending through the center line between the first and second coils. Since the currents of the first 2A and second 2B coil have opposite directions, also the field orientation of the magnetic fields generated by both coils is opposite with respect to each other. Since the opposite fields generated by the coils 2A, 2B superpose, there exists a line M between the first and second coils where the magnetic field nulls. This line is exactly the center line between the first and second coils when the coils are constructed in the same way and the currents are equal in magnitude. The resulting magnetic field strength varies along the x-direction in that it decreases from the generating coil to the line where the field nulls.

In Fig. 10c, the deflection force resulting from the above described magnetic field is depicted. Since the deflection force is oriented normal with respect to the magnetic field and the velocity of the electrons, the electrons are deflected in y-direction. Due to the variation of the magnetic field along the x-direction, also the strength of the deflection force varies along the x-direction.

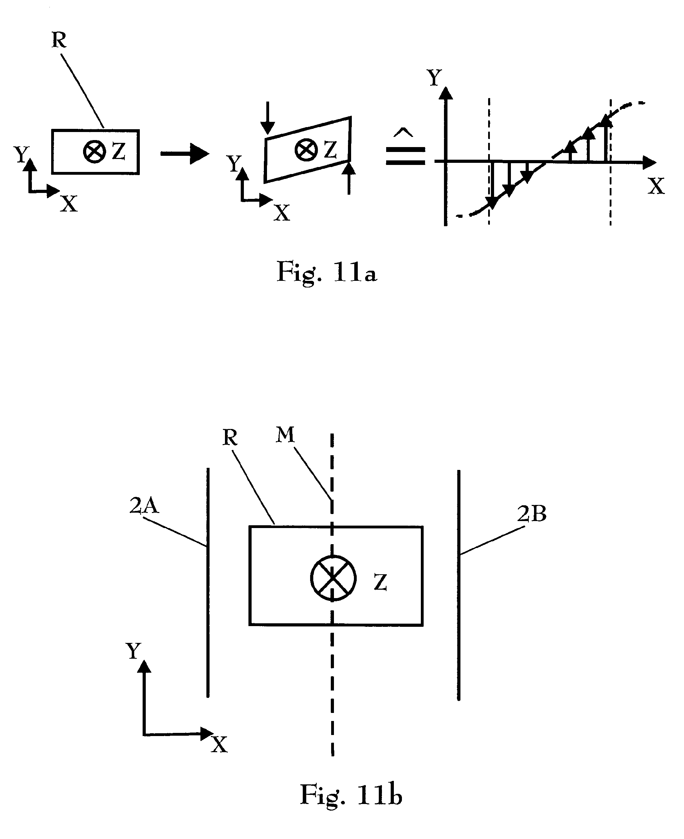

Next, the operation of the above described embodiment is explained with reference to Figs. 11a and 11b. On the left hand side of Fig. 11a, a skew operation is described which can be performed with the embodiment shown in Fig. 10a. As can be seen from Fig. 11a, the cross-section R of the beam is skewed in that it is pulled downward (-y) on the left end side and pulled upward (+y) on the right end side. The corresponding deflection amplitudes are depicted on the right hand side of Fig. 11a. Fig. 11b shows the geometry of the beam cross-section R and the coils 2A, 2B. The coils are oriented parallel to the y-z-plane and mirror-symmetric with respect to the mirror plane M extending through the center of the beam cross-section R.

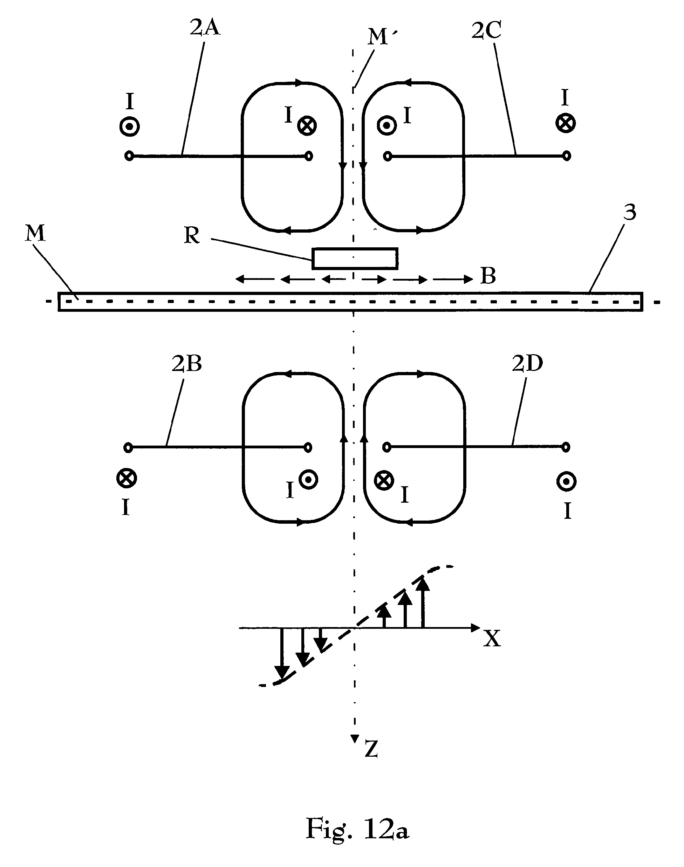

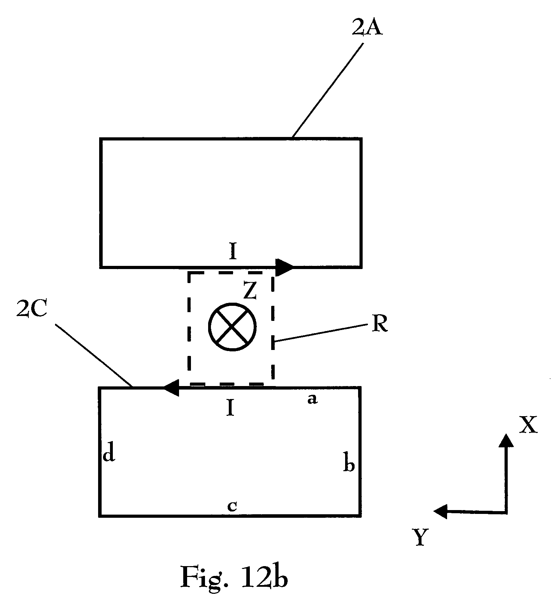

A further embodiment of the present invention is now described with reference to Figs. 12a and 12b. Fig. 12a is a sectional view of the deflector according to the present embodiment. The deflector comprises four identical coils 2A, 2B, 2C, 2D which are oriented parallel to a plane of interest M, e.g. parallel to the surface of wafer 3 disposed in the x-y-plane. Two coils 2A, 2C are disposed above wafer 3 and two coils 2B, 2D are disposed below wafer 3. Furthermore, the four coils have mirror-symmetry with respect to plane M as well as to a plane M' extending parallel to the y-z-plane.

Fig. 12b shows a plan view of the upper coils 2A, 2C which have segments a, c extending in y-direction and segments b, d extending in x-direction. In the present embodiment, it is preferred that the influence of the opposing a-segments of the coils on the beam cross-section R is greater than the influence of the other segments. Therefore, the a-segments of the coils 2A, 2B, 2C, 2D are preferably elongated compared to the length of the other coil segments. It is also preferred to have relatively long b- and d-segments so that the influence of the c-segments on the magnetic field in the region of interest, i.e. adjacent to the beam R, is weak or negligible. Accordingly, the beam is almost exclusively influenced by the local fields generated by the a-segments of the coils. The arrows indicate the opposite current directions in the coils.

Turning now back to Fig. 12a, it should be noted that the front view of Fig. 12a shows the d-segments of the coils. Furthermore, the current direction in the a- and c-segments is also indicated in Fig. 12a. As is apparent, the current directions of the upper coils 2a, 2C are opposite to each other. Similarly, the current directions of the lower coils 2B, 2D are also opposite to each other. Moreover, the current directions of the opposing upper and lower coils are also opposite to each other. The resulting magnetic fields of the a-segments are shown in Fig. 12a. In a center region (region of interest) comprising also the electron beam, the individual local fields of the a-segments add up to the B-field indicated by the arrows. In particular, the local fields superpose to form a magnetic field which is substantially parallel to the wafer 3 and directed outwardly from the symmetry plane M'. Since the influence of the local field generated by the a-segment of coil 2C on the local field generated by the a-segment of coil 2A and vice versa decreases with the distance from plane M', the magnetic field strength B of the resulting field increases with distance from plane M'. Consequently, also the deflection force implied by this field increases with distance from plane M' as is shown in the diagram below the apparatus. Accordingly, the above embodiment according to the present invention allows to generate a magnetic field deflecting a beam of charged particles in the y-direction by a deflection force varying along the x-direction. The above embodiment is especially useful in applications where a specimen 3 is used which has lateral extension preventing the use of vertically oriented coils as in the embodiment shown in Fig. 10a. An interference of vertical coils and a laterally extended specimen is avoided by the above embodiment of the present invention due to the coils being oriented parallel to the specimen. Furthermore, also in this embodiment the inhomogeneity of the deflection force can be electrically and thus simply controlled.

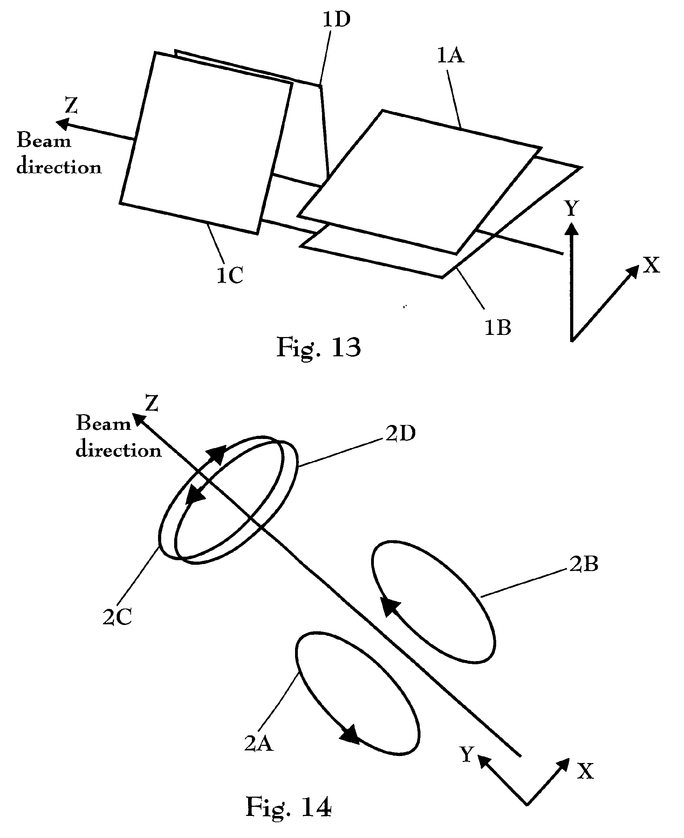

Next, further embodiments of the present invention are described with respect to Figs. 13 and 14. As has been described above with reference to Fig. 2, also subsequent skew operations are desirable to achieve a rotation, at least of first order, of the beam cross-section. Fig. 13 shows a deflector system which is an embodiment of the present invention, said deflector system comprising a first 1A, 1B and second pairs 1C, 1D of electrodes. The first pair of electrodes is angled with respect to the x-z-plane as described above with reference to Figs. 6a to c. Also the second pair 1C, 1D is angled, but with respect to the y-z-plane. In other words, the second pair 1C, 1D is arranged similar to the first pair 1A, 1B of electrodes, but rotated by 90° about the z-axis. Therefore, an electron beam is non-uniformly deflected in the y-direction by the first pair 1A, 1B of electrodes and, subsequently, non-uniformly deflected in the x-direction by the second pair 1C, 1D of electrodes. In other words, two skew operations are performed subsequently, resulting in the aforementioned rotation.

The embodiment of the present invention shown in Fig. 14 employs the same basic principle, i.e. subsequent skew operations are performed by a plurality of deflectors. Particularly, a first pair 2A, 2B of coils is disposed parallel to the y-z-plane, and a second pair 2C, 2D of coils is disposed parallel to the x-z-plane. In other words, the second pair 2C, 2D is arranged similar to the first pair 2A, 2B of coils, but rotated by 90° about the z-axis. Therefore, an electron beam is non-uniformly deflected in the y-direction by the first pair 2A, 2B of coils and, subsequently, non-uniformly deflected in the x-direction by the second pair 2C, 2D of coils. Thus, two skew operations are performed subsequently, resulting in the a rotation of the beam cross-section about the z-axis.

It should be noted that in the embodiments described with respect to Figs, 13 and 14 the choice of the electrodes or coils is only exemplary. In fact, an arbitrary combination of any of the aforementioned embodiments of deflectors can be chosen. Especially, two deflectors according to the embodiment shown in Fig. 8a can be combined, i.e. disposed on behind the other. Also, a pair of coils can be combined with a deflector formed by electrodes, etc.

## Claims

1. A deflector for imposing a deflection force on a beam of charged particles, wherein said deflection force varies within a region of interest along a first direction (X) substantially normal to the beam and is directed in a second direction (Y) substantially normal to the beam.

2. A deflector for imposing a deflection force on a beam of charged particles, comprising a pair of electrodes (1A, 1B) extending along the direction (Z) of the beam and a first direction (X) substantially normal to said direction (Z) of the beam, wherein a first electrode (1A) is oriented parallel to said first direction (X) and a second electrode (1B) is angled with respect to said first direction (X).

3. A deflector for imposing a deflection force on a beam of charged particles, comprising a pair of electrodes (1A, 1B) extending along the direction (Z) of the beam and a first direction (X) substantially normal to said direction (Z) of the beam, said pair of electrodes (1A, 1B) being angled with respect to said first direction (X).

4. The deflector according to claim 3, wherein the angle between a first electrode (1A) and said first direction (X) and the angle between a second electrode (1B) and said first direction (X) are equal in magnitude but have opposite sign.

5. A deflector for imposing a deflection force on a beam of charged particles, comprising
first (1A, 1B) and second (1C, 1D) pairs of electrodes extending along the direction of the beam (Z) and a first direction (X) substantially normal to said direction of the beam (Z),
said first and second pairs of electrodes (1A, 1B; 1C, 1D) being angled with respect to said first direction (X),
wherein the angle between a first electrode (1A) of said first pair and said first direction (X) and the angle between a second electrode (1B) of said first pair and said first direction (X) are equal in magnitude but have opposite sign, and
wherein the angle between a first electrode (1C) of said second pair and said first direction (X) and the angle between a second electrode (1D) of said second pair and said first direction (X) are equal in magnitude but have opposite sign, and
wherein the angle between said first electrode (1A) of said first pair and said first direction (X) and the angle between said second electrode (1D) of said second pair and said first direction (X) are equal in magnitude and sign, and
wherein the angle between said second electrode (1B) of said first pair and said first direction (X) and the angle between said first electrode (1C) of said second pair and said first direction (X) are equal in magnitude and sign.

6. The apparatus according to claim 5, wherein said first and second pairs of electrodes have mirror symmetry with respect to a plane (M) spanned by the center of the beam (Z) and the first direction and to a plane (M') spanned by the center of the beam (Z) and the second direction (Y).

7. A deflector for imposing a deflection force on a beam of charged particles, comprising at least four pairs (1Aa, 1Ba; 1Ab, 1Bb; 1Ca, 1Da; 1Cb, 1Db) of electrodes extending along the direction of the beam (Z) and a first direction (X) substantially normal to said direction of the beam (Z),
said four pairs being oriented parallel to a plane (M) spanned by the center of the beam (Z) and the first direction and being oriented normal to a plane (M') spanned by the center of the beam (Z) and a second direction (Y) substantially normal to the beam.

8. A deflector for imposing a deflection force on a beam of charged particles in a direction (Y) substantially normal to the beam, comprising at least two coils (2A, 2B), wherein said coils are oriented parallel to a plane spanned by said beam (Z) and said direction (Y) substantially normal to the beam.

9. The deflector of claim 8, wherein the at least two coils are substantially identically, preferably they have identical diameters and winding numbers.

10. A deflector for imposing a deflection force on a beam of charged particles, comprising first (2A, 2B) and second (2C, 2D) pairs of coils,
said first (2A, 2B) and second (2C, 2D) pairs of coils being oriented in a plane spanned by first (X) and second (Y) directions substantially normal to the beam,
wherein upper electrodes (2A, 2C) of said first and second pairs are disposed above a plane (3) of interest, and
wherein lower electrodes (2B, 2D) of said first and second pairs are disposed below said plane (3) of interest.

11. The deflector according to claim 10, wherein the segments (a, c) of said coils which extend in said second direction (Y) are much longer than the segments (b, d) extending in said first direction (X).

12. The deflector according to any of the preceding claims, wherein said deflection force varies substantially linearly within said region of interest.

13. The deflector according to any of the preceding claims, wherein the sign of the deflection force changes within said region of interest.

14. The deflector according to any of the preceding claims, wherein said deflection force is zero at the center of said region of interest.

15. The deflector of any of the preceding claims, wherein said beam has a rectangular or square cross-section.

16. The deflector according to any of the preceding claims, wherein said beam of charged particles comprises a plurality of subbeams.

17. A deflector system comprising at least two deflectors according to any of the preceding claims, wherein first (1A, 1B; 2A, 2B) and second (1C, 1D; 2C, 2D) deflectors are serially disposed downstream the direction (Z) of a beam of electrically charged particles, said second deflector being rotated around said beam about 90° with respect to said first deflector.

18. A charged particle beam apparatus, comprising
a plurality of cathodes oriented in a plane and positioned substantially parallel to a substrate surface, and
a deflector or deflector system according to any of the preceding claims.

19. The charged particle beam apparatus according to claim 18, wherein said plurality of cathodes is disposed within a rectangular or square array.

20. The charged particle beam apparatus according to claim 18 or 19,
wherein said plurality of cathodes is formed by an array of field emission cathodes.
